# EUROPEAN PATENT SPECIFICATION

(11) **EP 1 604 411 B1**
(45) Date of publication and mention of the grant of the patent: **29.09.2010**
(21) Application number: 04720906.9
(22) Date of filing: 16.03.2004
(51) Int. Cl.: H01L 51/30, C09K 11/06, H05B 33/14, C07F 15/00

(54) **METHOD FOR THE PRODUCTION OF METAL COMPLEXES**
VERFAHREN ZUR HERSTELLUNG VON METALLKOMPLEXEN
PROCÉDÉ DE PRODUCTION DE COMPLEXES MÉTALLIQUES

(30) Priority: 20.03.2003 GB 0306340
(43) Date of publication of application: 14.12.2005
(73) Proprietor: CDT Oxford Limited, Cambridgeshire CB3 6DW (GB)
(72) Inventor: LY, Tuan, Quoc, Littlemore, Oxford OX4 4XG (GB)
(74) Representative: Gilani, Anwar
(86) International application number: PCT/GB2004/001106
(87) International publication number: WO 2004/084326

(56) References cited:
- EP-A- 1 239 526
- EP-A- 1 348 711
- EP-A- 1 349 435
- US-A1- 2002 024 293
- US-A1- 2002 034 656
- US-A1- 2002 182 441
- PATENT ABSTRACTS OF JAPAN vol. 2002, no. 08, 5 August 2002 (2002-08-05) -& JP 2002 105055 A (FUJI PHOTO FILM CO LTD), 10 April 2002 (2002-04-10)
- LAMANSKY S ET AL: "SYNTHESIS AND CHARACTERIZATION OF PHOSPHORESCENT CYCLOMETALATED IRIDIUM COMPLEXES" INORGANIC CHEMISTRY, AMERICAN CHEMICAL SOCIETY. EASTON, US, vol. 40, no. 7, 3 January 2001 (2001-01-03), pages 1704-1711, XP002272499 ISSN: 0020-1669
- COLOMBO M G ET AL: "FACIAL TRIS CYCOMETALATED RH3+ AND IR3+ COMPLEXES: THEIR SYNTHESIS, STRUCTURE, AND OPTICAL SPECTROSCOPIC PROPERTIES" INORGANIC CHEMISTRY, AMERICAN CHEMICAL SOCIETY, EASTON, US, vol. 33, 1994, pages 545-550, XP002255816 ISSN: 0020-1669 cited in the application
- KING K A ET AL: "EXCITED-STATE PROPERTIES OF A TRIPLY ORTHO-METALATED IRIDIUM (III) COMPLEX" JOURNAL OF THE AMERICAN CHEMICAL SOCIETY, AMERICAN CHEMICAL SOCIETY, WASHINGTON, DC, US, vol. 107, no. 107, 1985, pages 1431-1432, XP001069823 ISSN: 0002-7863

## Description

### Field of the Invention

The present invention relates to a method of producing metal complexes.

### Background of the Invention

One class of opto-electrical devices attracting increasing attention is that using a semiconducting organic material for light emission (an electroluminescent device) or as the active component of a photocell or photodetector (a "photovoltaic" device). The basic structure of these devices is a semiconducting organic layer sandwiched between a cathode for injecting or accepting negative charge carriers (electrons) and an anode for injecting or accepting positive charge carriers (holes) into the organic layer.

In an organic light emitting device (OLED), electrons and notes are injected into the semiconducting organic layer where they combine to generate excitons that undergo radiative decay. Various classes of organic light emitting materials are known, in particular: polymers such as poly(p-phenylene vinylene) (as disclosed in WO 90/13148), polyfluorenes and polyphenylenes; the class of materials known as small molecule materials such as (8-hydroxyquinoline) aluminium ("Alq3") as disclosed in US 4,539,507; and the class of materials known as dendrimers as disclosed in WO 99/21935. These materials electroluminesce by radiative decay of singlet excitons (i.e. fluorescence) however spin statistics dictate that up to 75% of excitons are triplet excitons, i.e. quantum efficiency may be as low as 25% for fluorescent OLEDs - see, for example, Chem. Phys. Lett., 1993, 210, 61, Nature (London), 2001, 409, 494, Synth. Met., 2002, 125, 55 and references therein.

Accordingly, considerable effort has been directed towards producing luminescence from triplet excitons (phosphorescence) by utilising metal complexes that enable triplet excitons to undergo radiative decay. Examples of complexes investigated for this purpose include lanthanide metal chelates [Adv. Mater., 1999, 11, 1349], a platinum (II) porphyrin [Nature (London), 1998, 395, 151] and iridium tris(phenylpyridine) [Appl. Phys. Lett., 1999, 75, 4; Appl. Phys. Lett., 2000, 77, 904]. Fuller reviews of such complexes may be found in Pure Appl. Chem., 1999, 71, 2095, Materials Science & Engineering, R: Reports (2002), R39(5-6), 143-222 and Polymeric Materials Science and Engineering (2000), 83, 202-203.

One approach to synthesis of these metal complexes is described in, for example, WO 02/15645, US 2002/034656, JP 2002-105055 and references therein. This is a two-step process, as illustrated in Scheme 1 for an asymmetric complex comprising phenylpyridine:
1) Formation of a chloro-bridged dimer (a).
2) Reaction of the dimer in the presence of a base and ligand to form the end product (b). 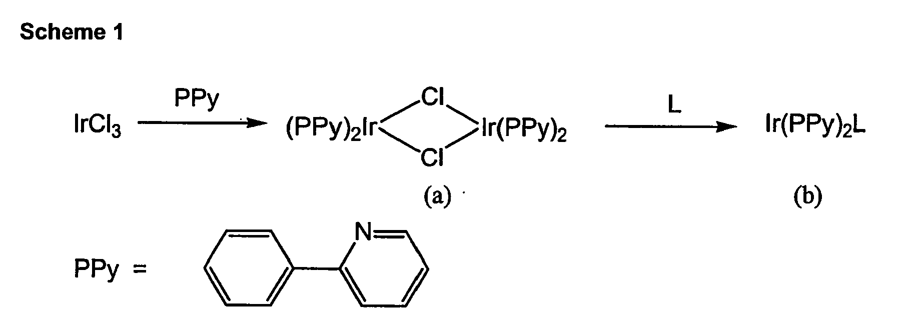 L = bidentate ligand

It will be appreciated by the skilled person that this two-step process for iridium complexes is applicable to a wider range of metal complexes that form bridged dimers. Other metals that form halo-bridged dimers include rhodium, palladium and platinum (see, for example, Inorg. Chem. 2002, 41, 3055).

These prior art syntheses of organometallic complexes entail a two-step process because the chloro-bridged dimer (a) is a relatively stable material. The chloro bridge of the dimer cannot be broken by a ligand such as phenylpyridine and so the second step requires a ligand L that is capable of breaking the chloro bridge, thus making this synthesis suitable only for asymmetric complexes (i.e. those wherein L is not PPy).

It is possible to form tris(phenylpyridine) iridium (III) by reaction of phenylpyridine with dimer (a) by performing the reaction in the presence of a salt such as silver triflate as described in Inorganic Chemistry (1994), 33(3), 545-50 and Chemical Communications (Cambridge, United Kingdom) (2001), (16), 1494-1495. This approach has the drawback that residual silver may be present in the end product which can be difficult to separate from the end product and which may be detrimental to OLED performance. Furthermore, this approach has only been reported for the synthesis of symmetric complexes (i.e. those wherein L = PPy). "Symmetric complexes" as used herein means complexes wherein all ligands attached to the metal are the same; "asymmetric complexes" as used herein means complexes wherein at least one of the ligands attached to the metal is differs from at least one other ligand attached to the metal.

An alternative synthesis of iridium complexes is described, for example, in WO 02/60910 and US 2002/034656 wherein *tris*-acetylacetonate iridium(III) is reacted with 3 equivalents of phenylpyridine. This has the drawback that *tris*-acetylacetonate iridium is relatively expensive in comparison to iridium chloride (from which it is made). It is possible to prepare *tris*-acetylacetonate iridium by reaction of iridium trichloride and 2,5-pentanedione, however this adds an additional step to the synthesis (the inventors have found that it is not possible to react iridium trichloride with 2-phenylpyridine in the presence of 2,5-pentanedione because this results in degradation of the reactants). Furthermore, this one-step approach does not allow formation of asymmetric complexes.

In view of the aforementioned drawbacks of prior art syntheses, it is an object of the invention to provide a method of reacting halo-bridged iridium, rhodium, platinum or palladium dimers with ligands that are incapable of breaking the halo bridge of the dimer, but without the need for metal containing reagents other than the dimer itself. It is a further object of the invention to provide a one-pot process for synthesising said complexes that is suitable for synthesising both symmetric and asymmetric complexes (by "one-pot" as used herein is meant a process wherein the intermediate halogen bridged dimer formed in the first step is not separated from some or all of the components of the reaction mixture in which it is formed prior to the second step). It is a yet further object of the invention to provide a method for synthesising said complexes in a one-pot process without the need for costly starting materials.

### Summary of the Invention

In a first aspect the invention provides a method of forming a metal complex of formula M(Ar¹Ar²)ₙL comprising the step of reacting a compound of formula (I) with a bidentate ligand L: 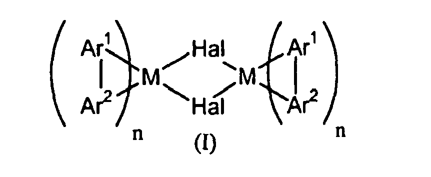 wherein Ar¹ and Ar² are each independently an optionally substituted aryl or heteroaryl; Ar¹-Ar² forms at least one carbon-M bond by reaction of M with a carbanion of Ar¹-Ar²; L is a compound of formula Ar¹-Ar²; M is iridium, rhodium, platinum or palladium; Hal is a halogen; and n is a number from 1-3 having a value necessary to satisfy the valency of metal M,
**characterised in that** the reaction is performed in the presence of an enabling ligand that is not a compound of formula L and that is capable of breaking the halogen bridge of the compound of formula (I).

By "bidentate ligand" is meant a ligand which, when present in a metal complex, is bound to the metal by two ligand-metal bonds. Each of the ligand-metal bonds may be a covalent or co-ordination bond.

Preferably, each Hal is bromine, chlorine or iodine, most preferably chlorine.

Preferably, Ar¹-Ar² is phenylpyridine.

In a first embodiment, Ar¹-Ar² and L are the same. In a second embodiment, Ar¹-Ar² and L are different.

In one embodiment of the first aspect of the invention, the enabling ligand is a monodentate ligand, more preferably a ligand selected from optionally substituted pyridine and triarylphosphine.

In another embodiment of the first aspect of the invention, the enabling ligand is a bidentate ligand of formula (IIb): 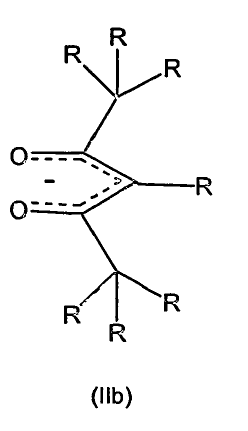 wherein each R is independently selected from H or a substituent. Preferably, each R is hydrogen.

Preferably, the ligand of formula (IIb) is formed by treating a corresponding protonated compound with a metal-free base.

Preferably, the reaction is performed in a protic solvent, preferably ethylene glycol.

In a preferred embodiment, the invention provides a method of forming a metal complex of formula M(Ar¹Ar²)ₙL comprising a first step of preparing a compound of formula (I) by reacting a compound of formula M(Hal)ₘ with a compound of Ar¹-Ar² and a second step according to the first aspect of the invention, wherein m is a number necessary to satisfy the valency of M, **characterised in that** the first and second steps are performed in a one-pot process.

In a second aspect, the invention provides a method of forming a metal complex comprising:
a) a first step of reacting a compound of formula M(Hal)ₘ with a compound of formula Ar¹-Ar² to form a compound of formula (I): 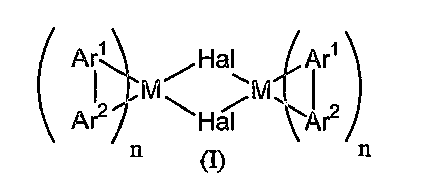 and
b) a second step of reacting the compound of formula (I) with a reactive ligand that is not a compound of formula Ar¹-Ar² and that is capable of breaking the halogen bridge of the compound of formula (I)
   wherein Ar¹ and Ar² are each independently an optionally substituted aryl or heteroaryl; Ar¹-Ar² forms at least one carbon-M bond by reaction of M with a carbanion of Ar¹-Ar²; L is a compound of formula Ar¹-Ar²; M is iridium, rhodium, platinum or palladium; Hal is a halogen; m is a number from 2-8 and n is a number from 1-3, m and n each having a value necessary to satisfy the valency of metal M,
**characterised in that** the first and second steps are performed in a one-pot process.

By "metal halide" is meant a compound comprising at least two metal-halogen bonds, including compounds of formula M(Hal)ₓ(L')y wherein M is a metal, Hal is a halogen, L' is a mono- or multi-dentate ligand, x is greater than or equal to 2, y is greater than or equal to 0, and x+y is a number necessary to satisfy the valency of M.

The present inventors have surprisingly found that it is possible to form various metal complexes by reaction of a halo-bridged dimer with a bidentate ligand L in the presence of the aforementioned enabling ligands whereas said metal complexes do not form when the enabling ligand is absent. Thus, use of these enabling ligands allows a broader range both of products (symmetric and asymmetric) and of reaction conditions.

The formation of said metal complexes is made possible by the fact that the enabling ligand is capable of breaking the relatively stable halogen bridge of dimer (I) to form an a relatively reactive intermediate that is then capable of reacting with bidentate ligand Ar¹-Ar². This is illustrated in Scheme 2 wherein the enabling ligand is a monodentate ligand L^{m} (e.g. pyridine).

Furthermore, as shown in Scheme 2, the first step of the inventive process entails synthesis of the dihalo bridged dimer (I) as per the prior art. To produce the final product, prior art syntheses entail separation of the dimer (I) and subsequent reaction with bidentate ligand L. By contrast, the present inventors have surprisingly found that the final product (IV) may be formed by reacting the dimer (I) *in situ* with ligand L in the presence of monodentate ligand L^{m}, i.e. without having to first separate dimer (I). It will be appreciated, however, that the reaction can also be performed as a "two-pot" process, for example wherein the dimer (I) is formed in a first, protic, solvent such as ethylene glycol and subsequently reacted in a second, aprotic, solvent such as dichloromethane.

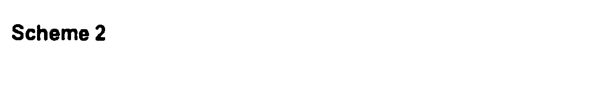

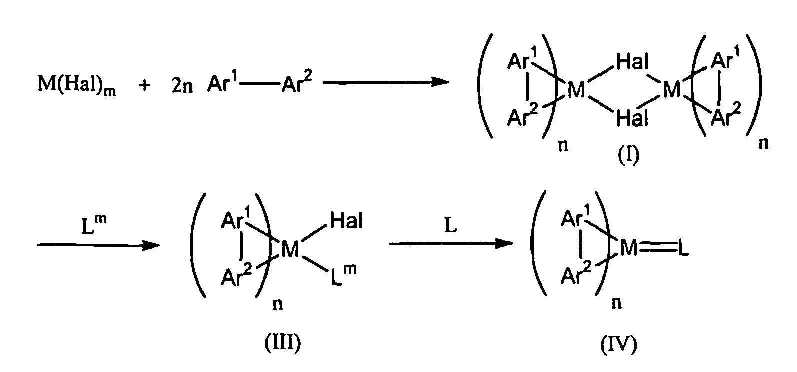

Alternatively, certain bidentate ligands may be used as enabling ligands.

In addition to using ligands that are capable of breaking the halogen bridge as enabling ligands, these ligands may also be used as reactants ("reactive ligands") in a one-pot process for formation of asymmetric complexes. In this instance, the compound of formula (III) is the end product rather than an intermediate. Products of this type are known as disclosed in, for example, WO 02/15645 however prior art syntheses entail a two-pot process.

The present invention enables the preparation of symmetric or asymmetric metal complexes from a halo-bridged dimer, or in a one-pot process starting from the corresponding metal halide, without the need for silver salts as per the prior art.

### Detailed Description of the Invention

Ar¹-Ar² and L may be the same or different. In the process of Scheme 2, L is added in the final step of the reaction, however L may be included in the starting mixture with Ar¹-Ar², particularly if Ar¹-Ar² and L are the same. If Ar¹-Ar² and L are different then addition of L in the final step is preferred in order to produce a single asymmetric complex.

In addition to being linked to M through a carbanion, Ar¹-Ar² in compounds of formula III may be linked to metal M by a metal-nitrogen bond.

Ar¹ and Ar² are preferably selected from the group consisting of optionally substituted phenyl and optionally substituted heteroaromatics comprising a 5 or 6 membered ring, either as a part of a monocyclic or fused ring system. Particularly preferred heteroaromatics ring systems are those comprising one or more oxygen, sulfur or nitrogen atoms.

L is selected from the same group of compounds as Ar¹-Ar², i.e. those compounds that are incapable of breaking the halogen bridge. For any method according to the invention, L and Ar¹-Ar² may be the same (for production of a symmetric complex) or different (for production of an asymmetric complex). L must be capable of displacing the enabling ligand.

Ligands capable of breaking the halogen bridge of the metal dimer (i.e. enabling ligands or reactive ligands) are selected from monodentate ligands or certain bidentate ligands.

Particularly preferred monodentate ligands are selected from the group consisting of optionally substituted phosphines, particularly triaryl- or trialkyl-phosphines, most preferably triphenylphosphine; optionally substituted electron rich 6-membered nitrogen containing heteroaromatics, preferably optionally substituted pyridine, diazines or triazines, most preferably pyridine.

Monodentate enabling ligands are preferred for synthesis of asymmetric complexes.

Suitable bidentate ligands for use as enabling or reactive ligands include bidentate ligands that bind to metal M through one or more oxygen atoms. One particularly preferred class of bidentate ligand are ligands of formula (IIb): 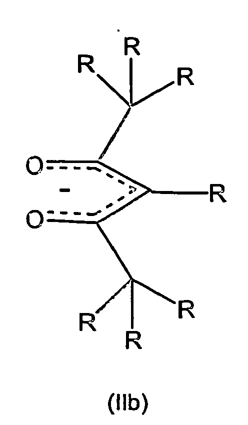 wherein each R is independently selected from hydrogen or a substituent. When two or more groups R are a substituent, they may together form an alicyclic or aromatic ring. Preferably, each R is hydrogen.

It will be appreciated that the ligand of formula (IIb) is formed by treatment of the corresponding protonated compound with a base capable of deprotonating said compound.

An alternative preferred enabling or reactive bidentate ligand is optionally substituted picolinate of formula (V):

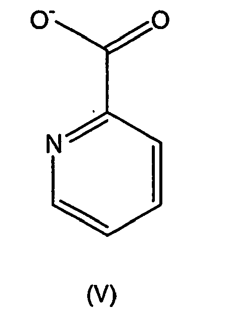

Where two or more substituents are present, they may together form an alicyclic or aromatic ring.

A further preferred class of enabling or reactive bidentate ligand is that which binds to metal M through two nitrogen-metal bonds, in particular optionally substituted ligands of formula (VI): 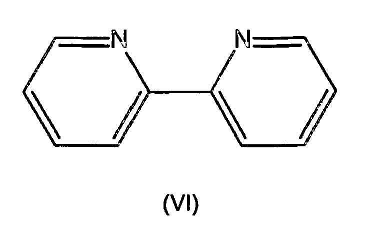 wherein each pyridyl ring is optionally substituted and wherein two or more of said substituents may form an alicyclic or aromatic ring.

Where the bidentate ligand derived from the compound of formula (IIb) is used, either as an enabling ligand or as a reactive ligand, all groups R are preferably H or C₁₋₁₀ alkyl, more preferably H. The compound of formula (IIb) is preferably deprotonated by a metal-free base. Particularly preferred metal-free bases include ammonium containing bases such as ammonium hydroxide or ammonium carbonate or organic bases such as trialkyl- or triaryl-amines, particularly C₁₋₁₀ alkylamines, most particularly triethylamine.

Suitable solvents for the one-pot process according to the invention are protic solvents, preferably diols, most preferably ethylene glycol.

Numerous examples of materials suitable for use as Ar¹-Ar² and L are known as disclosed in, for example, WO 02/15645. Preferably, each Ar¹-Ar² and each L comprises a nitrogen atom capable of forming a co-ordination bond with a metal. Examples of Ar¹-Ar² and L include the following: 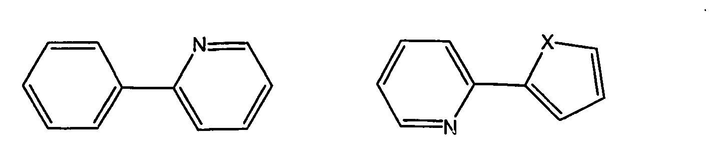 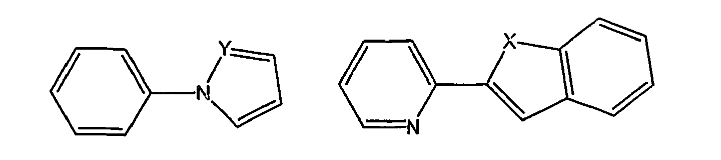 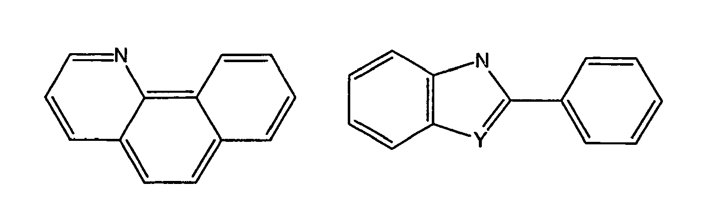 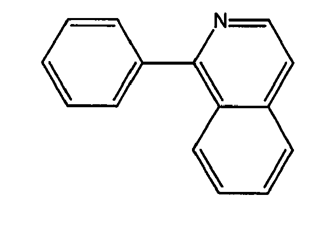 X = O,S
Y = C,N

Each of the above groups Ar¹-Ar² may carry one or more substituents. Particularly preferred substituents include fluorine or trifluoromethyl which may be used to blue-shift the emission of the complex as disclosed in WO 02/45466, WO 02/44189, US 2002-117662 and US 2002-182441; alkyl or alkoxy groups as disclosed in JP 2002-324679; carbazole which may be used to assist hole transport to the complex when used as an emissive material as disclosed in WO 02/81448; bromine, chlorine or iodine which can serve to functionalise the ligand for attachment of further groups as disclosed in WO 02/68435 and EP 1245659; and dendrons which may be used to obtain or enhance solution processability of the metal complex as disclosed in WO 02/66552.

### Examples

### Example 1 - synthesis of Ir(ppy)₃ from dimer

A reaction mixture of [Ir(ppy)₂Cl]₂ (1.30 g, 1.21 mmol), 2-phenylpyridine (0.40 g, 2.58 mmol), 2,4-pentanedione (0.27 g, 2.70 mmol), triethylamine (0.27 g, 2.67 mmol) and anhydrous ethylene glycol (20 ml) was heated at reflux for 3 days in a nitrogen atmosphere. The reaction mixture was allowed to cool to room temperature. The yellow precipitate was filtered, washed with water (3 x 100 ml) followed by ethanol (3 x 100 ml) and finally dried. A yield of 1.36 g (99 %) of Ir(ppy)₃ was collected.

¹H [300 MHz, CDCl₃]: 7.88 (1H, d, Ar), 7.66 (1H, d-d, Ar), 7.58 (1H, d-t, Ar), 7.53 (1H, d-d, Ar), 6.85 (4H, m, Ar).

### Example 2 - one-pot synthesis of Ir(ppy)₃ from IrCl₃

A reaction mixture of IrCl₃.3H₂O (0.20 g, 0.57 mmol), 2-phenylpyridine (0.30 g, 1.93 mmol) and anhydrous ethylene glycol (20 ml) was heated at reflux for 18 h in a nitrogen atmosphere. The initial black suspension turned to yellow precipitate, indicating formation of the chloro-bridged dimer. The mixture was allowed to cool to room temperature followed by addition of 2,4-pentanedione (0.18 g, 1.80 mmol) and triethylamine (0.18 g, 1.80 mmol). The mixture was heated at reflux for 3 days and then cooled to room temperature. The yellow ppt was filtered, washed with water (3 x 50 ml) followed by ethanol (3 x 50 ml) and finally dried. A yield of 0.22 g (60 %) Ir(ppy)₃was collected.

¹H [300 MHz, CDCl₃]: 7.88 (1H, d, Ar), 7.66 (1H, d-d, Ar), 7.58 (1H, d-t, Ar), 7.53 (1H, d-d, Ar), 6.85 (4H, m, Ar).

### Example 3 - synthesis of Ir(Brppy)₃ from dimer

A reaction mixture of [Ir(Brppy)₂Cl]₂ (2.60 g, 1.87 mmol), bromophenylpyridine (1.00 g, 4.27 mmol), 2,4-pentanedione (0.40 g, 4.00 mmol), triethylamine (0.40 g, 3.96 mmol) and anhydrous ethylene glycol (20 ml) was heated at reflux for 24 h. in a nitrogen atmosphere and then allowed to cool to room temperature. The yellow ppt was filtered, washed with water (3 x 100 ml) followed by ethanol (3 x 100 ml) and finally dried. A yield of 2.50 g (75 %) Ir(Brppy)₃ was collected.

¹H [300 MHz, dmso-d₆]: 8.22 (1H, d, Ar), 7.93 (1H, d, Ar), 7.82 (1H, d-t, Ar), 7.45 (1H, d-d, Ar), 7.17 (1H, d-t, Ar), 6.85 (1H, d-d, Ar), 6.49 (1H, d, Ar).

The method of the invention is suitable for the preparation of metal complexes for use as active components of organic optical devices such as organic electroluminescent or photovoltaic devices, in particular as phosphorescent materials in organic electroluminescent devices. However, it will be apparent that metal complexes prepared according to the invention are also suitable for other applications.

Although the present invention has been described in terms of specific exemplary embodiments, it will be appreciated that various modifications, alterations and / or combinations of features disclosed herein will be apparent to those skilled in the art without departing from the scope of the invention as set forth in the following claims.

## Claims

1. A method of forming a metal complex of formula M(Ar¹Ar²)ₙL comprising the step of reacting a compound of formula (I) with a bidentate ligand L: 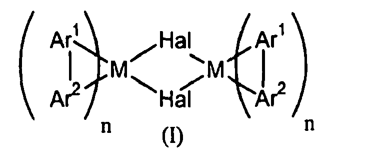 wherein Ar¹ and Ar² are each independently an optionally substituted aryl or heteroaryl; Ar¹-Ar² forms at least one carbon-M bond by reaction of M with a carbanion of Ar¹-Ar²; L is a compound of formula Ar¹-Ar²; M is iridium, rhodium, platinum or palladium; Hal is a halogen; and n is a number from 1-3 having a value necessary to satisfy the valency of metal M,
**characterised in that** the reaction is performed in the presence of an enabling ligand that is not a compound of formula L and that is capable of breaking the halogen bridge of the compound of formula (I).

2. A method according to claim 1 wherein Hal is bromine, chlorine or iodine, preferably chlorine.

3. A method according to any preceding claim wherein Ar¹-Ar² is phenylpyridine.

4. A method according to any preceding claim wherein Ar¹-Ar² and L are the same.

5. A method according to any preceding claim wherein Ar¹-Ar² and L are different.

6. A method according to any preceding claim wherein the enabling ligand is a monodentate ligand.

7. A method according to claim 6 wherein the monodentate ligand is selected from optionally substituted pyridine and triarylphosphine.

8. A method according to any one of claims 1-5 wherein the enabling ligand is a bidentate ligand of formula (IIb): 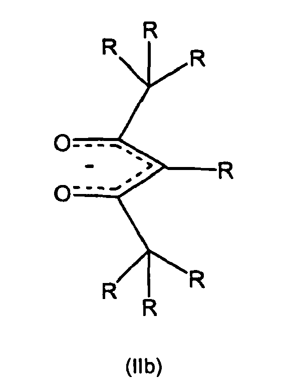 wherein each R is independently selected from H or a substituent.

9. A method according to claim 8 wherein the ligand of formula (lib) is formed by treatment of a corresponding protonated compound with a metal-free base.

10. A method according to claim 8 or 9 wherein each R is hydrogen.

11. A method of forming a metal complex of formula M(Ar¹Ar²)ₙL comprising a first step of preparing a compound of formula (I) by reacting a compound of formula M(Hal)ₘ with a compound of Ar¹-Ar² and a second step according to any preceding claim, wherein m is a number necessary to satisfy the valency of M, **characterised in that** the first and second steps are performed in a one-pot process.

12. A method according to any preceding claim wherein the reaction is performed in a protic solvent, preferably ethylene glycol.

13. A method of forming a metal complex comprising:
a) a first step of reacting a compound of formula M(Hal)ₘ with a compound of formula Ar¹-Ar² to form a compound of formula (I): 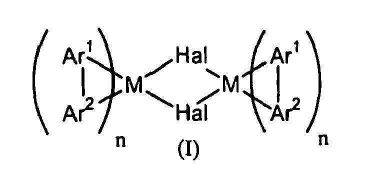 and
b) a second step of reacting the compound of formula (I) with a reactive ligand that is not a compound of formula Ar¹-Ar² and that is capable of breaking the halogen bridge of the compound of formula (I)
wherein Ar¹ and Ar² are each independently an optionally substituted aryl or heteroaryl; Ar¹-Ar² forms at least one carbon-M bond by reaction of M with a carbanion of Ar¹-Ar²; L is a compound of formula Ar¹-Ar²; M is iridium, rhodium, platinum or palladium; Hal is a halogen; m is a number from 2-8 and n is a number from 1-3, m and n each having a value necessary to satisfy the valency of metal M,
**characterised in that** the first and second steps are performed in a one-pot process.

## Patentansprüche

1. Verfahren zum Bilden eines Metallkomplexes der Formel M(Ar¹Ar²)ₙL, umfassend den Schritt des Reagierens einer Verbindung der Formel (I) mit einem zweizähnigen Liganden L: 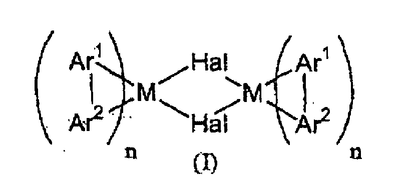 wobei Ar¹ und Ar² jeweils unabhängig ein wahlweise substituiertes Aryl oder Heteroaryl sind; Ar¹-Ar² durch Reaktion von M mit einem Carbanion von Ar¹-Ar² mindestens eine Kohlenstoff-M-Bindung bildet; L eine Verbindung der Formel Ar¹-Ar² ist; M Iridium, Rhodium, Platin oder Palladium ist; Hal ein Halogen ist; und n eine Zahl von 1-3 ist, die einen Wert besitzt, der erforderlich ist, um der Valenz des Metalls M zu genügen,
**dadurch gekennzeichnet, dass** die Reaktion in Gegenwart eines ermöglichenden Liganden durchgeführt wird, der keine Verbindung der Formel L ist Verbindung der Formel (I) zu brechen.

2. Verfahren nach Anspruch 1, wobei Hal Brom, Chlor oder Iod, bevorzugt Chlor ist.

3. Verfahren nach einem der vorhergehenden Ansprüche, wobei Ar¹-Ar² Phenylpyridin ist.

4. Verfahren nach einem der vorhergehenden Ansprüche, wobei Ar¹-Ar² und L gleich sind.

5. Verfahren nach einem der vorhergehenden Ansprüche, wobei Ar¹-Ar² und L verschieden sind.

6. Verfahren nach einem der vorhergehenden Ansprüche, wobei der ermöglichende Ligand ein einzähniger Ligand ist.

7. Verfahren nach Anspruch 6, wobei der einzähnige Ligand unter wahlweise substituiertem Pyridin und Triarylphosphin ausgewählt wird.

8. Verfahren nach einem der Ansprüche 1-5, wobei der ermöglichende Ligand ein zweizähniger Ligand der Formel (IIb): 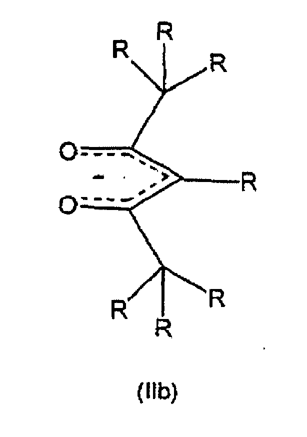 ist, wobei jedes R unabhängig unter H oder einem Substituenten ausgewählt wird.

9. Verfahren nach Anspruch 8, wobei der Ligand der Formel (IIb) durch Behandlung einer entsprechenden protonierten Verbindung mit einer metallfreien Base gebildet wird.

10. Verfahren nach Anspruch 8 oder 9, wobei jedes R Wasserstoff ist.

11. Verfahren zum Bilden eines Metallkomplexes der Formel M(Ar¹Ar²)ₙL, umfassend einen ersten Schritt des Herstellens einer Verbindung der Formel (I) durch Reagieren einer Verbindung der Formel M(Hal)ₘ mit einer Verbindung von Ar¹-Ar² und einen zweiten Schritt nach einem der vorhergehenden Ansprüche, wobei m eine Zahl, die erforderlich ist, um der Valenz von M zu genügen, **dadurch gekennzeichnet, dass** die ersten und zweiten Schritte durch ein Eintopfverfahren durchgeführt werden.

12. Verfahren nach einem der vorhergehenden Ansprüche, wobei die Reaktion in einem protischen Lösungsmittel, bevorzugt Ethylenglykol, durchgeführt wird.

13. Verfahren zum Bilden eines Metallkomplexes, umfassend:
a) einen ersten Schritt des Reagierens einer Verbindung der Formel M(Hal)ₘ mit einer Verbindung der Formel Ar¹-Ar² unter Bildung einer Verbindung der Formel (I) 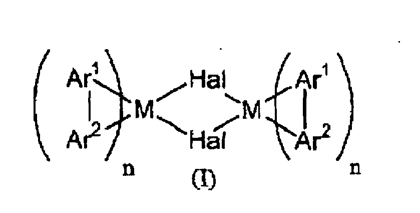 und
b) einen zweiten Schritt des Reagierens der Verbindung der Formel (I) mit einem reaktiven Liganden, der keine Verbindung der Formel Ar¹-Ar² ist und der in der Lage ist, die Halogenbrücke der Verbindung der Formel (I) zu brechen
wobei Ar¹ und Ar² jeweils unabhängig ein wahlweise substituiertes Aryl oder Heteroaryl sind; Ar¹-Ar² durch Reaktion von M mit einem Carbanion von Ar¹-Ar² mindestens eine Kohlenstoff-M-Bindung bildet; L eine Verbindung der Formel Ar¹-Ar² ist; M Iridium, Rhodium, Platin oder Palladium ist; Hal ein Halogen ist; m eine Zahl von 2-8 ist und n eine Zahl von 1-3 ist, wobei m und n jeweils einen Wert besitzen, der erforderlich ist, um der Valenz des Metalls M zu genügen,
**dadurch gekennzeichnet, dass** die ersten und zweiten Schritte durch ein Eintopfverfahren durchgeführt werden.

## Revendications

1. Procédé de formation d'un complexe métallique de la formule M(Ar¹Ar²)ₙL comprenant l'étape de réaction d'un composé de la formule (I) avec un ligand L bidenté : 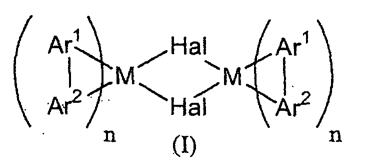 dans laquelle Ar¹ et Ar² sont chacun indépendamment un groupe aryle ou hétéroaryle éventuellement substitué ; Ar¹-Ar² forme au moins une liaison carbone-M par réaction du M avec un carbanion d'Ar¹-Ar² ; L représente un composé de la formule Ar¹-Ar² ; M représente un atome iridium, rhodium, platine ou palladium ; Hal représente un halogène ; et n représente un nombre de 1 à 3 avec une valeur nécessaire pour satisfaire la valence du métal M,
**caractérisé en ce que** la réaction est exécutée en présence d'un ligand validant qui n'est pas un composé de la formule L et qui peut rompre le pont halogène du composé de la formule (I).

2. Procédé selon la revendication 1, dans lequel Hal représente un atome de brome, de chlore ou d'iode, de préférence un atome de chlore.

3. Procédé selon l'une quelconque des revendications précédentes, dans lequel Ar¹-Ar² est de la phénylpyridine.

4. Procédé selon l'une quelconque des revendications précédentes, dans lequel Ar¹-Ar² et L sont identiques.

5. Procédé selon l'une quelconque des revendications précédentes, dans lequel Ar¹-Ar² et L sont différents.

6. Procédé selon l'une quelconque des revendications précédentes, dans lequel le ligand validant est un ligand monodenté.

7. Procédé selon la revendication 6, dans lequel le ligand monodenté est choisi parmi une pyridine éventuellement substituée et une triarylphosphine.

8. Procédé selon l'une quelconque des revendications 1 à 5, dans lequel le ligand validant est un ligand bidenté de la formule (IIb) : 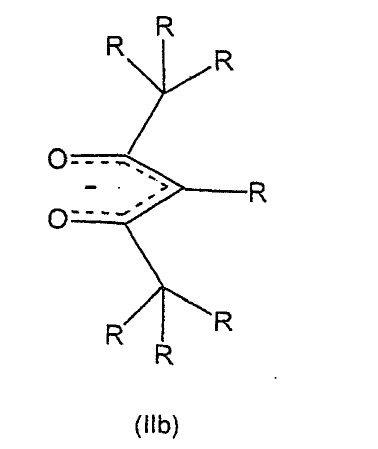 dans laquelle chaque R est choisi indépendamment parmi un atome H ou un substituant.

9. Procédé selon la revendication 8, dans lequel le ligand de la formule (IIb) est formé par traitement d'un composé protoné correspondant avec une base exempte de métal.

10. Procédé selon la revendication 8 ou 9, dans lequel chaque R représente un atome hydrogène.

11. Procédé de formation d'un complexe métallique de la formule M(Ar¹Ar²)ₙL comprenant une première étape de préparation d'un composé de la formule (I) par réaction d'un composé de la formule M(Hal)ₘ avec un composé Ar¹Ar² et une seconde étape selon l'une quelconque des revendications précédentes, dans lequel m représente un nombre nécessaire pour satisfaire la valence de M, **caractérisé en ce que** les première et seconde étapes sont exécutées dans un procédé monotope.

12. Procédé selon l'une quelconque des revendications précédentes, dans lequel la réaction est exécutée dans un solvant protique, de préférence de l'éthylèneglycol.

13. Procédé de formation d'un complexe métallique comprenant :
a) une première étape de réaction d'un composé de la formule M(Hal)ₘ avec un composé de la formule Ar¹Ar² pour former un composé de la formule (I) : 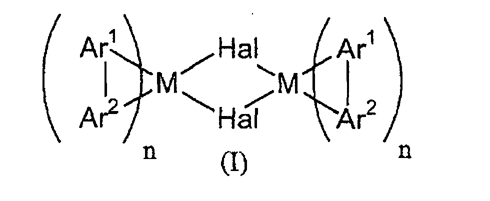 et
b) une seconde étape de réaction du composé de la formule (I) avec un ligand réactif qui n'est pas un composé de la formule Ar¹Ar² et qui peut rompre le pont halogène du composé de la formule (I)
dans lequel Ar¹ et Ar² sont chacun indépendamment un groupe aryle ou hétéroaryle éventuellement substitué ; Ar¹-Ar² forme au moins une liaison carbone-M par réaction du M avec un carbanion d'Ar¹-Ar² ; L représente un composé de la formule Ar¹-Ar² ; M représente un atome iridium, rhodium, platine ou palladium ; Hal représente un halogène ; m représente un nombre de 2 à 8 et n représente un nombre de 1 à 3, m et n ayant chacun une valeur nécessaire pour satisfaire la valence du métal M,
**caractérisé en ce que** les première et seconde étapes sont exécutées dans un procédé monotope.
